# EUROPÄISCHE PATENTANMELDUNG

(11) **EP 4 709 063 A1**
(43) Veröffentlichungstag der Anmeldung: **11.03.2026**
(21) Anmeldenummer: 24201402.5
(22) Anmeldetag: 19.09.2024
(51) Int. Cl.: H05K 1/14, H05K 1/11, H05K 1/02

(54) **SPANNUNGSWANDLER UND VERFAHREN ZUM HERSTELLEN EINES SPANNUNGSWANDLERS**

(30) Priorität: 05.09.2024 EP 24198616
(71) Anmelder: Infineon Technologies Austria AG, 9500 Villach (AT)
(72) Erfinder: RAINER, Christian Stefan, 9064 Magdalensberg (AT)
(74) Vertreter: Kraus & Lederer PartGmbB

(57) **Zusammenfassung**

Es wird ein Spannungswandler (10), bereitgestellt, umfassend:
- eine erste Leiterplatte (11) mit einem ersten Schaltungsabschnitt (13) des Spannungswandlers (10), wobei der erste Schaltungsabschnitt (13) zwischen Metalllagen der ersten Leiterplatte (11) eingebettete Halbleiterchips (15) umfasst, und
- eine zweite Leiterplatte (12) mit einem zweiten Schaltungsabschnitt (14) des Spannungswandlers (10), wobei der erste Schaltungsabschnitt (13) elektrisch mit dem zweiten Schaltungsabschnitt (14) gekoppelt ist.

## Beschreibung

### TECHNISCHES GEBIET

Die vorliegende Anmeldung betrifft Spannungswandler sowie Verfahren zum Herstellen von Spannungswandler.

### HINTERGRUND

Spannungswandler sind Schaltungen, welche eine Eingangsspannung in eine Ausgangsspannung, welche für eine bestimmte Anwendung benötigt wird, wandeln. Ein Typ von Spannungswandler sind Gleichspannungs-Gleichspannungswandler (DC/DC-Wandler, vom englischen "direct current"), welche eine Eingangsspannung in eine Ausgangsgleichspannung wandeln.

Derartige DC/DC-Wandler werden beispielsweise in Beschleunigerkarten für künstliche Intelligenz (KI)-Anwendungen benötigt. Dabei werden derartige DC/DC Wandler direkt auf einer Beschleunigerkarte bereitgestellt, um eine genaue Spannungsregulierung und eine schnelle Antwort auf Laständerungen zu ermöglichen. Dies kann eine möglichst optimierte Leistungsversorgung für Prozessoren und andere Komponenten der Beschleunigerkarte bereitzustellen.

Dabei können verschiedene Wandlertopologien verwendet werden, beispielsweise isolierte oder nicht isolierte Topologien (das heißt mit und ohne galvanische Trennung zwischen Eingangsseite und Ausgangsseite, beispielsweise auf geschalteten Kondensatoren basierende Wandler, LLC-Wandler oder Abwärtswandler.

Der Platz, der auf solchen Beschleunigerkarten für DC/DC-Wandler zur Verfügung steht, ist beschränkt und beträgt in der Praxis, auch wenn dies nicht explizit genormt ist, üblicherweise derzeit 23 mm x 17 mm, das heißt ein Spannungswandlermodul muss auf dieser Fläche untergebracht werden. Trotz dieser Größenbeschränkungen muss der Spannungswandler eine gute Effizienz, das heißt geringe Leistungsverluste bieten, soll eine möglichst große Leistung bieten können und es ermöglichen können, die Temperaturen im Betrieb in akzeptablen Bereichen zu halten. Gleichzeitig soll die Lösung kostengünstig sein.

### KURZFASSUNG

Gemäß einer Ausführungsform wird ein Spannungswandler bereitgestellt, umfassend:
- eine erste Leiterplatte mit einem ersten Schaltungsabschnitt des Spannungswandlers, wobei der erste Schaltungsabschnitt zwischen Metalllagen der ersten Leiterplatte eingebildete Halbleiterchips umfasst, und
- eine zweite Leiterplatte mit einem zweiten Schaltungsabschnitte Spannungswandlers, wobei der erste Schaltungsabschnitt elektrisch mit dem zweiten Schaltungsabschnitt gekoppelt ist.

Gemäß einer anderen Ausführungsformen wird ein Verfahren zum Herstellen eines Spannungswandlers bereitgestellt, umfassend: Bereitstellen einer ersten Leiterplatte mit einem ersten Schaltungsabschnitt des Spannungswandlers, wobei der erste Schaltungsabschnitt zwischen Metalllagen der ersten Leiterplatte eingebetteter Halbleiterchips umfasst, Bereitstellen einer zweiten Leiterplatte mit einem zweiten Schaltungsabschnitte Spannungswandlers, und elektrisches Koppeln des ersten Schaltungsabschnitts mit dem zweiten Schaltungsabschnitt.

Die obige Kurzfassung gibt nur einen kurzen Überblick über manche Ausführungsformen und ist nicht als einschränkend auszulegen.

### KURZBESCHREIBUNG DER ZEICHNUNGSFIGUREN

Fig. 1 ist ein Schemadiagramm eines Spannungswandlers gemäß einer Ausführungsform.
Figur 2A ist eine Perspektivansicht eines Spannungswandlers gemäß einer Ausführungsform.
Figur 2B ist eine Seitenansicht des Spannungswandlers der Figur 2A.
Die Figur 2C ist eine Draufsicht auf den Spannungswandler der Figuren 2A und 2B.
Die Figur 2D ist eine Ansicht von unten des Spannungswandlers der Figuren 2A bis 2C.
Die Figuren 2E und 2F sind Schnittansichten in einer Leiterplatte des Spannungswandlers der Fig. 2A bis 2D.
Die Figur 2G zeigt eine alternative Ausführungsform.
Die Fig. 3 ist eine Querschnittsansicht einer Leiterplatte eines Spannungswandlers gemäß mancher Ausführungsformen.
Die Figuren 4A bis 4C zeigen einen Spannungswandler gemäß einer Ausführungsform mit einer Wärmeleitplatte, wobei die Fig. 4A eine Ansicht entsprechend der Figur 2C zeigt und die Figuren 4B und 4C Ansichten der Wärmeleitplatte zeigen.
Die Figuren 5A und 5B zeigen Details der Kopplung zwischen Leiterplatten bei verschiedenen Ausführungsformen.
Die Fig. 6 zeigt ein Schaltungsdiagramm eines Spannungswandlers, mit einer Aufteilung auf Leiterplatten gemäß mancher Ausführungsformen.
Die Fig. 7 zeigt ein Schaltungsdiagramm eines weiteren Spannungswandlers, mit einer Aufteilung auf Leiterplatten gemäß mancher Ausführungsformen.
Die Fig. 8 zeigt ein Flussdiagramm eines Verfahrens gemäß manche Ausführungsformen.

### DETAILLIERTE BESCHREIBUNG

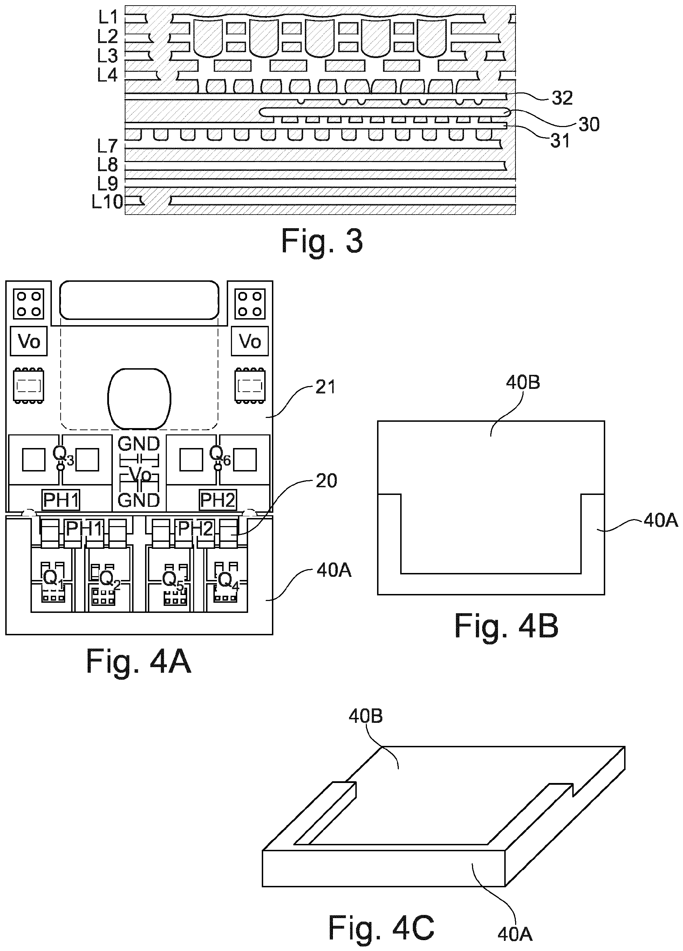

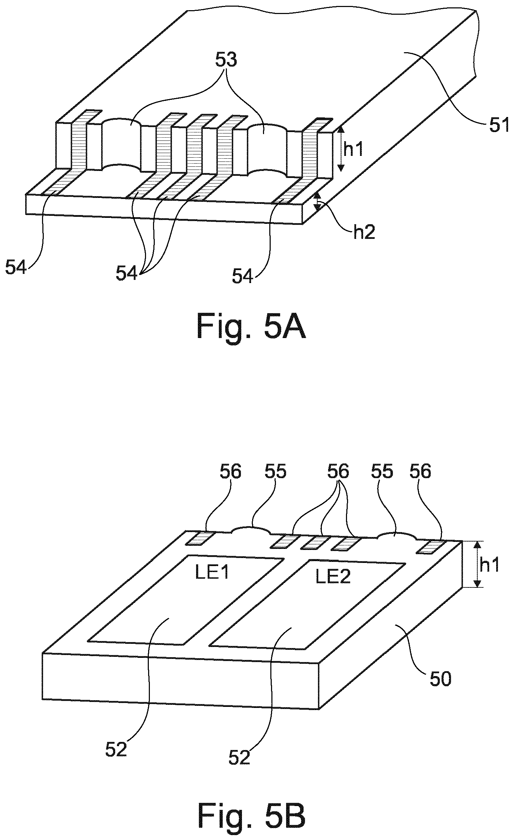

Im Folgenden werden verschiedene Ausführungsformen detailliert erläutert. Diese Ausführungsbeispiele dienen der Veranschaulichung und sind nicht als einschränkend auszulegen. Details, Merkmale oder Variationen, die für eines der Ausführungsbeispiele beschrieben werden, sind auch auf andere Ausführungsbeispiele anwendbar und werden daher nicht wiederholt beschrieben. Merkmale verschiedener beschriebener Ausführungsbeispiele sind miteinander kombinierbar, sofern nichts anderes angegeben ist. So wird beispielsweise unter Bezugnahme auf die Figuren 4A bis 4C eine spezielle Wärmeleitplatte beschrieben, die bei Ausführungsbeispielen anwendbar ist, und unter Bezugnahme auf die Figuren 5A und 5B wird eine bestimmte Kopplung zwischen Leiterplatten beschrieben. Die Wärmeleitplatte und die Kopplung können unabhängig voneinander, aber auch gemeinsam eingesetzt werden. Ähnliches gilt für andere beschriebene Merkmale.

In verschiedenen beschriebenen Ausführungsbeispielen wird eine Spannungswandlerschaltung in zwei Schaltungsabschnitte aufgeteilt, welche auf verschiedenen Leiterplatten bereitgestellt sind. Auf einer der Schaltleiterplatten werden dabei eingebettete Halbleiterchips, das heißt Halbleiterchips, die zwischen verschiedenen Metalllagen der Leiterplatte eingebetteter sind, eingesetzt. Wie im Folgenden näher beschrieben wird, kann hiermit eine verbesserte Implementierung verglichen mit der Verwendung einer einzigen Leiterplatte für die Spannungswandlerschaltung erreicht werden.

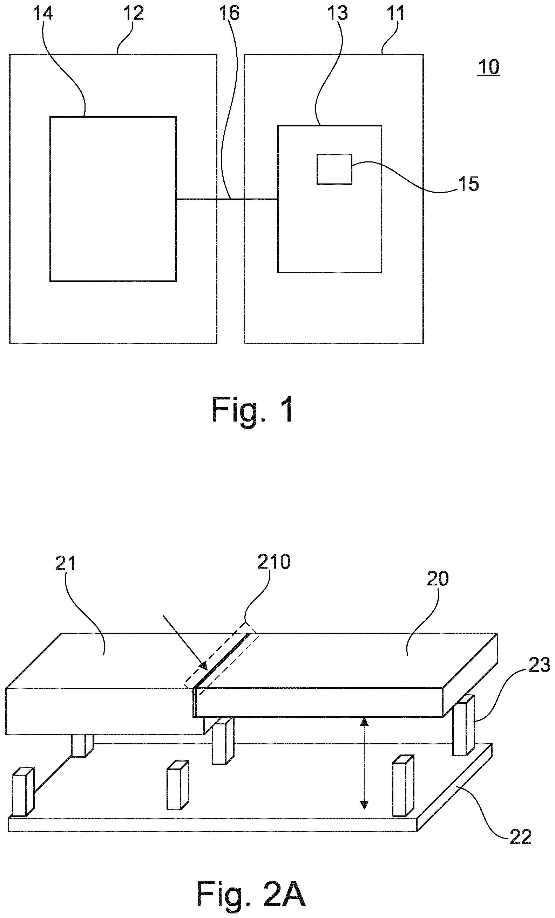

Die Fig. 1 zeigt einen Spannungswandler 10 gemäß einem Ausführungsbeispiel. Der Spannungswandler 10 umfasst eine erste Leiterplatte 11 (im englischen "printed circuit board", PCB), und eine zweite Leiterplatte 12. Auf der ersten Leiterplatte 11 ist ein erster Schaltungsabschnitt 13 des Spannungswandlers 10 angeordnet, und auf der zweiten Leiterplatte 12 ist ein zweiter Schaltungsabschnitt 14 des Spannungswandlers angeordnet. Der erste Schaltungsabschnitt 13 ist mit dem zweiten Schaltungsabschnitt 14 durch eine elektrische Kopplung 16 elektrisch gekoppelt. Auch wenn die elektrische Kopplung 16 in Fig. 1 schematisch als einzelne Linie dargestellt ist, kann sie eine Vielzahl einzelner elektrischer Verbindungen umfassen. Der erste Schaltungsabschnitt 13 und der zweite Schaltungsabschnitt 14 bilden zusammen eine Spannungswandlerschaltung, insbesondere eine Gleichstrom-Gleichstrom-Spannungswandlerschaltung. Der erste und zweite Schaltungsabschnitt können jeweils diskrete Komponenten, beispielsweise Kondensatoren, Widerstände, Transistoren, Spulen, Transformatoren etc., in Metalllagen der jeweiligen Leiterplatte realisierte Komponenten wie Spulen oder auch integrierte Schaltungen enthalten.

Der erste Schaltungsabschnitt 13 weist einen oder mehrere zwischen Metalllagen der ersten Leiterplatte 11 eingebettete Halbleiterchips 15 auf. Diese Halbleiterchips können insbesondere einen oder mehrere Transistoren, welche beispielsweise als Schalter in dem Spannungswandler dienen können, beinhalten. Derartige Transistoren können auf Siliziumbasis oder auch auf Basis anderer Halbleitermaterialien implementiert sein. Beispielsweise können Halbleitermaterialien mit großer Bandlücke, wie beispielsweise GaN-Transistoren wie GaN-HEMTs (High electron mobility Transistor) verwendet werden.

Zur Veranschaulichung zeigt die Fig. 3 hierzu einen Aufbau, bei dem ein Halbleiterchip 30 zwischen Metalllagen 31,32 einer Leiterplatte eingebettet ist. Mit L1-L4 und L7-L10 sind weitere Metalllagen bezeichnet, die wie dargestellt durch vertikale Verbindungen miteinander verbunden sein können. Die dargestellte Ausgestaltung der Metalllagen ist dabei nur als Beispiel zu verstehen, und die Metalllagen können eingerichtet sein, wie es für eine jeweilige Verdrahtung des Halbleiterchip und des übrigen ersten Schaltungsabschnitts erforderlich ist. Die Metalllagen sind wie üblich durch Dielektrika voneinander getrennt und können, wie insbesondere bei den Metalllagen 32 ersichtlich, durch senkrechte Verbindungen (zum Beispiel VIAs, Vertical Interconnect Access) miteinander verbunden sein.

Das Dielektrikum zwischen den Metalllagen stellt gleichsam eine Umhüllung für den Chip 30 bereit, während durch entsprechende Kontaktierungen der Chip 30 elektrisch mit Metalllagen verbunden ist.

Hierdurch können größere Halbleiterchips verwendet werden als mit nicht eingebetteten Halbleiterchips, die beispielsweise noch ein separates Package benötigen. Beispielsweise können hier Chips (Dies) verwendet werden, welche eine Chipfläche größer 7 mm², größer 8 mm², größer 10 mm² oder größer 12 mm² aufweisen, während bei herkömmlichen Lösungen mit diskreten Elementen auf einer Leiterplatte bei gleichem Gesamtplatz, der zur Verfügung steht, nur kleinere Chips verwendet werden können. Dies ermöglicht es beispielsweise, eine Anzahl von Transistoren bei gleicher Fläche zu erhöhen und somit Spannungswandler für höhere Leistungen, höhere Spannungen und/oder höheren Strömen bereitzustellen.

Der erste Schaltungsabschnitt 13 kann ausgelegt sein, im Betrieb des Spannungswandlers geringere Ströme zu führen als der zweite Schaltungsabschnitt. Bei typischen Schaltspannungswandler Implementierungen gibt es Schaltungsteile, die relativ geringe Ströme führen, beispielsweise weil sie im Wesentlichen nur Spannungspotenziale schalten, während andere Teile höhere Ströme führen, insbesondere ein Ausgangsabschnitt, von dem eine Last mit Leistung versorgt wird. Auf diese Weise können die jeweiligen Leiterplatten hinsichtlich ihres Aufbaus auf den verschiedenen Stromführungsbedarf abgestimmt werden.

So kann eine Anzahl von Metalllagen in der ersten Leiterplatte 11 kleiner sein als eine Anzahl von Metalllagen in der zweiten Leiterplatte 12. Die Verwendung von zwischen Metalllagen der ersten Leiterplatte 11 eingebetteten Halbleiterchips kann einen größeren Abstand von Metalllagen erfordern. Auf der anderen Seite können, wenn wie oben angesprochen der erste Schaltungsabschnitt geringere Ströme führt als der zweite Schaltungsabschnitt, weniger Metalllagen ausreichend sein, um den Strom mit geringen Verlusten zu führen. So kann beispielsweise die erste Leiterplatte 11 zwischen 6 und 10 Metalllagen aufweisen, während die zweite Leiterplatte 12 zwischen 16 und 20 Metalllagen aufweisen kann.

Diese Metalllagen der zweiten Leiterplatte 12 können einen geringeren Abstand aufweisen als ein Abstand zwischen den Metalllagen der ersten Leiterplatte 11, so dass sich hier ein höherer Metallgehalt ergibt. Das Metall kann insbesondere Kupfer, wie bei Leiterplatten üblich, sein, welches den Strom besonders gut leitet. Auf diese Weise können Verluste in der zweiten Leiterplatte 12 geringer gehalten werden, da aufgrund des höheren Metallanteils größerer Leitungsquerschnitte bereitgestellt werden können, um Strom in der zweiten Leiterplatte 12 zu führen. Auch können in den Metalllagen der zweiten Leiterplatte 12 ein oder mehrere Spulen für hohe Ströme ausgelegt implementiert werden, beispielsweise in Form von einzelnen Spulen oder Transformatoren wie Autotransformatoren oder planaren Transformatoren. Hier können sich eine oder mehrere Windungen einer derartigen Spule auch über mehrere Metalllagen parallel erstrecken.

Durch die geringere Anzahl von Metalllagen kann die erste Leiterplatte 11 auch insgesamt dünner sein als die zweite Leiterplatte 12, was mehr Platz für Bauteile auf der ersten Leiterplatte oder auch an anderen Stellen bieten kann.

Die erste Leiterplatte 11 und die zweite Leiterplatte 12 können über einer dritten Leiterplatte angeordnet sein. Ein entsprechendes Ausführungsbeispiel wird nun unter Bezugnahme auf die Figuren 2A bis 2D erläutert.

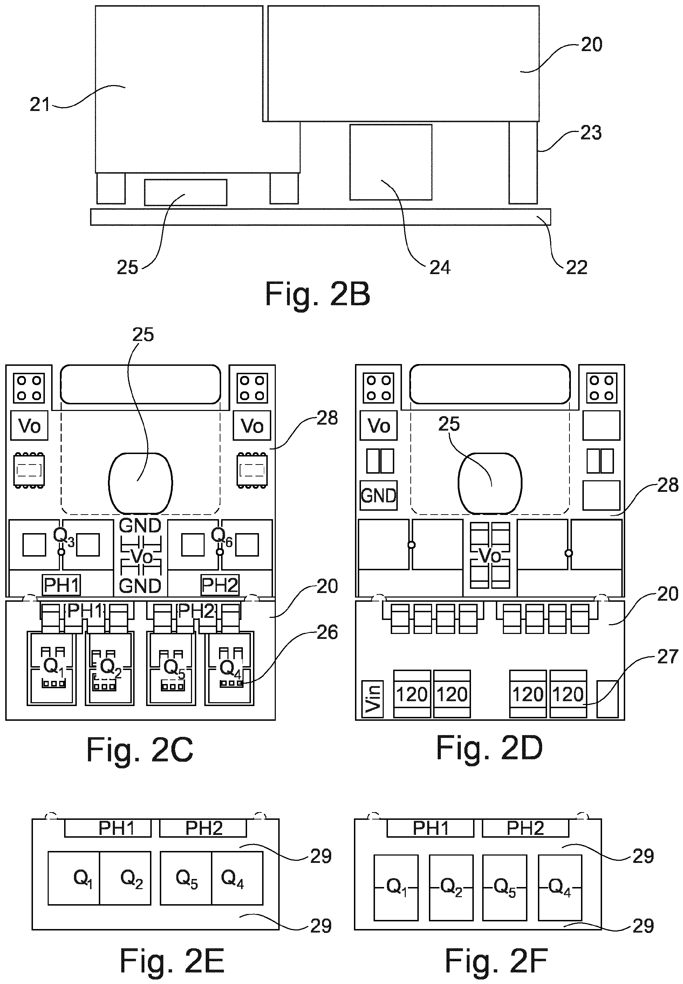

Die Fig. 2A zeigt eine Perspektivansicht, und die Figur 2B zeigt eine Seitenansicht eines Spannungswandlers gemäß einem Ausführungsbeispiel. Der Spannungswandler umfasst eine erste Leiterplatte 20 und eine zweite Leiterplatte 21, die in einem Kopplungsbereich 210 elektrisch und mechanisch gekoppelt sind. Wie insbesondere in der Figur 2B ersichtlich weist die zweite Leiterplatte 21 dabei eine stufenförmige Aussparung auf, in die die erste Leiterplatte eingreift.

Die erste Leiterplatte 20 und die zweite Leiterplatte 21 sind über einer dritten Leiterplatte 22 angeordnet und von dieser durch Stützelemente 23 beabstandet. Die Elemente 23 können dabei auch elektrische Verbindungen aufweisen oder bilden, um den Verbund aus erster Leiterplatte 20 und zweiter Leiterplatte 21 elektrisch mit der dritten Leiterplatte 22 und darauf befindlichen Bauelementen zu koppeln.

Die dritte Leiterplatte 22 kann vergleichsweise wenige Metalllagen, beispielsweise 4 Metalllagen, insbesondere weniger Metalllagen als die erste Leiterplatte 20 und die zweite Leiterplatte 21, aufweisen und kann Abmessungen haben, wie sie zum Einsatz des Spannungswandlers in einem System gefordert sind, beispielsweise die oben erwähnten Abmessungen von 23 mm x 17 mm, was ein Quasi-Standard für Gleichspannungs-Gleichspannungswandler für KI-Anwendungen ist.

Wie in Fig. 2B gezeigt, können auf der dritten Leiterplatte 22 Komponenten 24, 25, die zur Kommunikation mit einem jeweiligen System, in welchem der Spannungswandler eingesetzt wird, dienen, bereitgestellt sein. Die Komponenten 24,25 können unter der ersten Leiterplatte 20 eine größere Höhe aufweisen als unter der zweiten Leiterplatte 21, da die erste Leiterplatte 20 dünner ist.

Die Figur 2C zeigt eine Beispielansicht auf die erste und zweite Leiterplatte 20, 21 von oben, das heißt von der der dritten Leiterwandplatte 22 abgewandten Seite, und die Fig. 2D zeigt eine entsprechende Ansicht von unten. Die Figuren 2E und 2F zeigen Schnittansichten der ersten Leiterplatte 20, welche eingebettete Halbleiterchips aufweist. Wie aus den Figuren 2C und 2D ersichtlich können verschiedene Bauelemente auf beiden Seiten der ersten Leiterplatte 20 und der zweiten Leiterplatte 21 angeordnet sein. Dies beinhaltet integrierte Schaltungen 28 sowie Transistorelemente Q₃, Q₆ und eine Spulenanordnung 25 für die zweite Leiterplatte 21 und beispielsweise Kondensatoren 27 und Treiberschaltungen 26 für Transistoren eingebetteter Transistorchips (siehe Fig. 2E und 2F) für die erste Leiterplatte 20. Die Kondensatoren 27 können durch die geringere Dicke der ersten Leiterplatte 20 größer dimensioniert sein als bei manchen herkömmlichen Implementierungen. Die erste Leiterplatte 20 und die zweite Leiterplatte 21 kommunizieren über Kontaktelemente PH1, PH2 miteinander. In die erste Leiterplatte 20 sind, wie in den Schnittansichten der Figuren 2E und 2F gezeigt, Transistorchips Q₁, Q₂, Q₄ und Q₅ zwischen Metalllagen 29 (in der Ansicht der Fig. 2E und 2F oberhalb und unterhalb der Transistorchips dargestellt) eingebettet, wobei in der Fig. 2E zwei Kavitäten zwischen den Metalllagen bereitgestellt sind, wobei in jeder Kavität zwei Chips angeordnet sind (Q₁, Q₂ in der ersten Kavität und Q₄, Q₅ in der zweiten Kavität), während in Fig. 2F vier Kavitäten bereitgestellt sind, wobei hier auch in jeder Kavität zwei Chips angeordnet sind. Der Fall der Fig. 2F entspricht dem Fall, der auch in der Figur 2C angedeutet ist.

Schaltungselemente wie die Kondensatoren 27 können dann ganz oder teilweise über den Halbleiterchips angeordnet sein, was zu kurzen Verbindungswegen zwischen Transistoren in den Halbleiterchips und den Kondensatoren und somit zu geringen parasitären Kapazitäten führt.

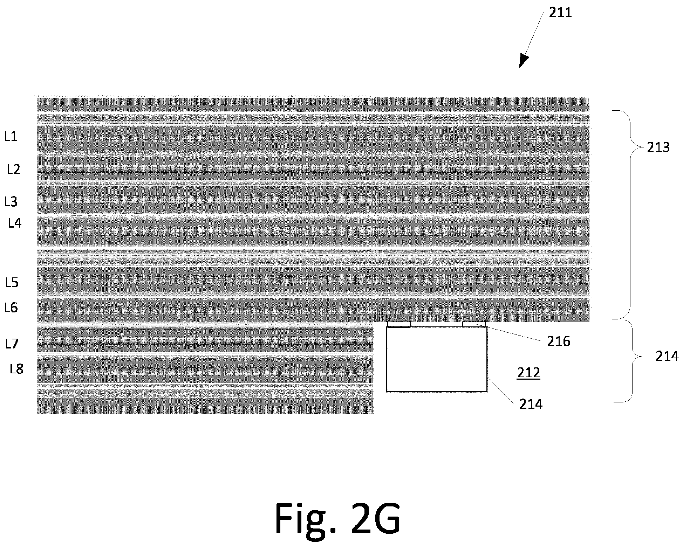

In einer weiteren Ausführungsform werden die Leiterplatten 20 und 21 nicht separat ausgeführt, sondern in einer einzigen Leiterplatte 211 ausgestaltet. Diese einzige Leiterplatte 211 zeigt im dargestellten Querschnitt Bereiche verschiedener Dicken. In dieser Ausführungsform sind die Metalllagen und zwischen den Metalllagen liegende andere Lagen, beispielsweise Dielektrika, wie in Figur 2G gezeigt, in 2 oder mehreren unterschiedlichen Längen ausgeführt. In dem Ausführungsbeispiel der Fig. 2G sind dabei die Lagen einschließlich Metalllagen L1 bis L6 in einem Bereich 213 länger als Lagen einschließlich Metalllagen L7 und L8 in einem Bereich 214. Hierdurch wird eine nutzbare Aussparung 212 gebildet wird. Die Aufteilung der Metalllagen auf die Bereiche ist dabei nur ein Beispiel, und es können auch andere Aufteilungen gewählt werden. Beispielsweise können beide Bereiche 213, 214 jeweils die gleiche Anzahl an Metalllagen oder unterschiedliche Anzahlen von Metalllagen aufweisen, und die Anzahl der insgesamt vorhandenen Metalllagen kann variieren.

Die Aussparung 212 kann Schaltungselemente 215 wie Kondensatoren oder auch kleinere Leiterplatten mit entsprechenden elektrischen Schaltungen platzsparend aufnehmen.

Insbesondere können die eingebrachten oder sich auf der eingebrachten Leiterplatte befindlichen elektrischen Komponenten höhere Ströme leiten, als die Komponenten, die auf der restlichen, größeren Leiterplatte 211 untergebracht sind.

Die Schaltungselemente 214, die in die Aussparung eingebracht werden, können mittels elektrischer Verbindungen 216 direkt mit einer angrenzenden Metalllage, hier der Metalllage L7 verbunden sein. Auf diese Art und Weise lassen sich auch größere Komponenten unterhalb des dünneren Bereichs einer Leiterplatte platzsparend integrieren.

Bei anderen Ausführungsbeispielen ist die Leiterplatte 211 über einer weiteren Leiterplatte (z.B. der oben beschriebenen Leiterplatte 22) angeordnet, und die Schaltungselemente 214 können zusätzlich oder alternativ mit dieser weiteren Leiterplatte elektrisch verbunden sein.

Die Verwendung der Leiterplatte 211 ist nicht auf Spannungswandler begrenzt.

Es wird also eine Leiterplatte bereitgestellt, umfassend eine Vielzahl von Metalllagen, die in einer ersten Richtung übereinander angeordnet sind, wobei Metalllagen der Vielzahl von Metalllagen in einem ersten Bereich, der sich in der ersten Richtung erstreckt, in mindestens einer von der ersten Richtung verschiedenen zweiten Richtung eine geringere Ausdehnung aufweisen als Metalllagen der Vielzahl von Metalllagen in einem von dem ersten Bereich verschiedenen zweiten Bereich, der sich ebenfalls in der ersten Richtung erstreckt. So kann eine Aussparung gebildet werden. In der Aussparung können ein oder mehrere Schaltungselemente bereitgestellt sein. Die Schaltungselemente können mit einer der Vielzahl von Metalllagen, insbesondere einer der Metalllagen in dem ersten Bereich, elektrisch gekoppelt sein.

Im Betrieb von Spannungswandlern entsteht Wärme beispielsweise durch Schaltverluste oder Fließen hoher Ströme. Zum Ableiten der Wärme wird herkömmlicherweise ein Kühlblech aus einem Metall mit guter Wärmeleitfähigkeit wie Kupfer oder Aluminium auf der ersten und/oder zweiten Leiterplatte angeordnet. Durch die Verwendung von eingebetteten Chips in der ersten Leiterplatte ist eine kompaktere Anordnung möglich, die es erlaubt, zusätzliche wärmeleitende Elemente seitlich an der ersten Leiterplatte anzuordnen. Ein entsprechendes Ausführungsbeispiel ist in den Figuren 4A bis 4C dargestellt.

Wie in der Fig. 4A gezeigt umgibt wärmeleitendes Material 40A die erste Leiterplatte 20 seitlich an drei Seiten. Das wärmeleitende Element 40A kann dabei insbesondere aus einem Metall gefertigt sein. Wie in den Figuren 4B und 4C gezeigt kann das wärmeleitende Element 40A mit einer Platte 40B verbunden sein, welche wie ein herkömmliches Kühlblech über der ersten Leiterplatte 20 und gegebenenfalls auch über einen Teil der zweiten Leiterplatte 21, beispielsweise den Bereich der Transistoren Q₃, Q₆, angeordnet wird. So kann bei derartigen Ausführungsbeispielen, verglichen mit der bloßen Bereitstellung eines Kühlblechs, für zusätzliche Kühlung gesorgt werden.

Für die Kopplung der ersten Leiterplatte mit der zweiten Leiterplatte sind verschiedene Varianten möglich. Ein mögliches Beispiel ist in den Figuren 5A und 5B gezeigt. Dabei zeigt die Fig. 5A ein Beispiel für eine zweite Leiterplatte 51, beispielsweise die zweite Leiterplatte 21 oder 12 aus den vorherigen Figuren, und die Fig. 5B zeigt ein Beispiel für eine erste Leiterplatte 50 mit eingebetteten Chips 52, welche ein Beispiel für die erste Leiterplatte 11 oder 20 sein kann. In dem dargestellten Beispiel weist die erste Leiterplatte 50 zwei Vorsprünge 55 auf, und die zweite Leiterplatte 51 weist zwei entsprechende Einkerbungen 53 auf. Im zusammengebauten Zustand greifen die Vorsprünge 55 in die Einkerbungen 53 ein, womit eine exakte Positionierung erreicht werden kann. Zudem weist die erste Leiterplatte 50 elektrische Kontakte 56 und die zweite Leiterplatte 51 elektrische Kontakte 54 auf, die bei dieser Positionierung miteinander in Kontakt treten und somit den jeweiligen ersten Schaltungsabschnitt mit dem jeweiligen zweiten Schaltungsabschnitt elektrisch verbinden. Die Anzahl von Kontakten 56 und Kontakten 54 und deren Anordnung passt dabei zueinander, ist jedoch hinsichtlich der Anordnung und Anzahl ansonsten nur als Beispiel zu verstehen, d.h. es können auch mehr oder weniger elektrische Kontakte je nach Bedarf für die jeweilige Spannungswandlerschaltung bereitgestellt sein. Auch ist Form, Anzahl und Positionierung der Vorsprünge 55 und der entsprechenden Einkerbungen 53 nur als Beispiel zu verstehen. Zudem können auch Befestigungsmittel wie Clips und dergleichen vorgesehen sein, um eine feste Verbindung zu bilden.

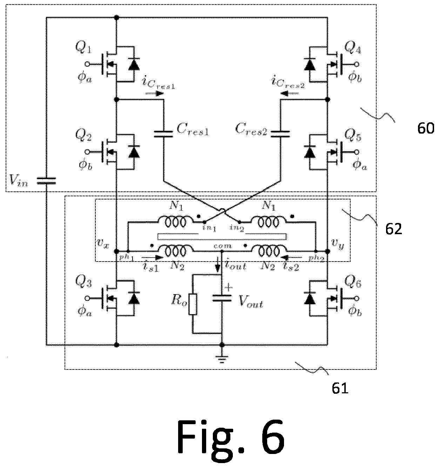

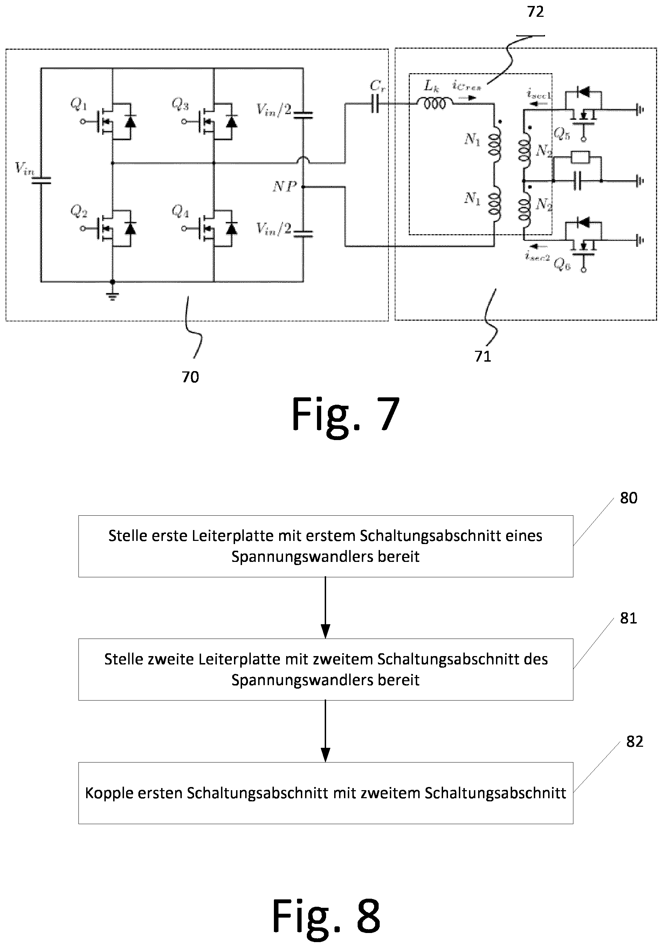

Wie bereits erläutert können verschiedene Spannungswandler verwendet werden. Die Figuren 6 und 7 zeigen zwei verschiedene mögliche Schaltungstopologien.

Die Fig. 6 zeigt ein Beispiel für einen sogenannten HSC-Wandler (hybrid switch capacitor converter), welcher auf einem Resonanzwandler mit zwei Phasen basiert. Ein Schaltungsabschnitt 60 führt im Betrieb geringen Strom und ist ein Beispiel für einen ersten Schaltungsabschnitt, der auf einer ersten Leiterplatte (z.B. 11, 20 oder 50) realisiert sein kann, und ein Schaltungsabschnitt 61 ist ein Beispiel für einen zweiten Schaltungsabschnitt, der auf einer zweiten Leiterplatte (z.B. 12, 21 oder 51) realisiert sein kann. Transistoren Q₁, Q₂, Q₄ und Q₅ des ersten Schaltungsabschnitts 60 können mittels eingebetteter Halbleiterchips implementiert sein, und die Kondensatoren C₁ und C₂ dann entsprechend als diskrete Kondensatoren, welche teilweise über den Halbleiterchips angeordnet sind. Eine Spulenanordnung 62 des zweiten Schaltungsabschnitts 61, die einen Transformator bildet, stellt ein Beispiel für eine Spulenanordnung dar, welche mittels einer oder mehrerer Windungen in Metalllagen der zweiten Leiterplatte realisiert sein kann.

Die Fig. 7 zeigt ein Beispiel für einen LLC-Halbbrücken Wandler. Hier kann ein erster Schaltungsabschnitt 70 wiederum auf der jeweiligen ersten Leiterplatte realisiert sein, und ein zweiter Schaltungsabschnitt 71 kann auf der jeweiligen zweiten Leiterplatte realisiert sein. Transistoren Q₁ bis Q₄ des ersten Schaltungsabschnitts 70 können als eingebettete Chips implementiert sein, und die dargestellten Kondensatoren können wiederum als diskrete Kondensatoren realisiert sein. Eine Spulenanordnung 72 einschließlich eines Kondensators stellt wiederum ein Beispiel für innerhalb der Metalllagen der zweiten Leiterplatte realisierbare Elemente dar.

Die Fig. 8 zeigt ein Flussdiagramm eines Verfahrens zum Herstellen eines Spannungswandlers gemäß mancher Ausführungsbeispiele. Das Verfahren der Fig. 8 kann beispielsweise zur Herstellung der oben beschriebenen Spannungswandler dienen und wird unter Bezugnahme auf diese beschrieben.

In Schritt 80 wird eine erste Leiterplatte mit einem ersten Schaltungsabschnitt eines Spannungswandlers bereitgestellt, wobei hierfür Halbleiterchips zwischen Metalllagen der ersten Leiterplatte eingebettet werden. Die erste Leiterplatte kann die erste Leiterplatte von irgendeinem der oben beschriebenen Ausführungsbeispiele sein.

In Schritt 81 wird eine zweite Leiterplatte mit einem zweiten Schaltungsabschnitt des Spannungswandlers bereitgestellt. Die zweite Leiterplatte kann die zweite Leiterplatte von irgendeinem der oben beschriebenen Ausführungsbeispiele sein. Die Schritte 80 und 81 können auch in umgekehrter Reihenfolge oder parallel durchgeführt werden. Bei 82 wird der erste Schaltungsabschnitt dann elektrisch mit dem zweiten Schaltungsabschnitt gekoppelt, beispielsweise wie oben, insbesondere unter Bezugnahme auf die Figuren 5A und 5B, beschrieben.

Der Verbund aus erste Leiterplatte und zweite Leiterplatte kann dann noch über einer dritten Leiterplatte angeordnet werden, wie dies in der Fig. 2A dargestellt ist.

Manche Ausführungsformen werden durch die folgenden Beispiele definiert:
Beispiel 1. Spannungswandler, umfassend:
   - eine erste Leiterplatte mit einem ersten Schaltungsabschnitt des Spannungswandlers, wobei der erste Schaltungsabschnitt zwischen Metalllagen der ersten Leiterplatte eingebettete Halbleiterchips umfasst, und
   - eine zweite Leiterplatte mit einem zweiten Schaltungsabschnitt des Spannungswandlers, wobei der erste Schaltungsabschnitt elektrisch mit dem zweiten Schaltungsabschnitt gekoppelt ist.
Beispiel 2. Spannungswandler nach Beispiel 1, wobei der erste Schaltungsabschnitt ausgelegt ist, im Betrieb des Spannungswandlers geringere Ströme zu führen als der zweite Schaltungsabschnitt.
Beispiel 3. Spannungswandler nach Beispiel 1 oder 2, wobei eine Anzahl von Metalllagen der ersten Leiterplatte kleiner ist als eine Anzahl von Metalllagen der zweiten Leiterplatte.
Beispiel 4. Spannungswandler nach einem der Beispiele 1 bis 3, wobei der zweite Schaltungsabschnitt eine Spule oder mehrere Spulen umfasst.
Beispiel 5. Spannungswandler nach einem der Beispiele 1 bis 4, wobei die erste Leiterplatte und die zweite Leiterplatte mechanische und elektrische Kopplungselemente aufweisen, welche eingerichtet sind, die erste und die zweite Leiterplatte mechanisch zu koppeln und die elektrische Kopplung des ersten Schaltungsabschnitts mit dem zweiten Schaltungsabschnitt bereitzustellen.
Beispiel 6. Spannungswandler nach Beispiel 5, wobei die mechanischen Kopplungselemente eine stufenförmige Aussparung in einer der ersten und der zweiten Leiterplatte umfassen, und wobei die andere der ersten und zweiten Leiterplatte in die stufenförmige Aussparung einpassbar ist.
Beispiel 7. Spannungswandler nach einem der Beispiele 1 bis 6, wobei die Halbleiterchips Transistoren beinhalten, wobei die erste Leiterplatte zudem in einer Draufsicht zumindest teilweise überlappend mit den Transistoren angeordnete Kondensatoren umfasst.
Beispiel 8. Spannungswandler nach einem der Beispiele 1 bis 7, wobei die erste Leiterplatte eine Seitenwand oder mehrere Seitenwände aus wärmeleitfähigem Material umfasst.
Beispiel 9. Spannungswandler nach Beispiel 8, wobei die mehreren Seitenwände eine U-Form bilden.
Beispiel 10. Spannungswandler nach einem der Beispiele 1 bis 9, wobei die Halbleiterchips eine Fläche größer als 7 mm² aufweisen.
Beispiel 11. Spannungswandler nach einem der Beispiele 1 bis 10, weiter umfassend eine dritte Leiterplatte mit Kontaktelementen, welche eingerichtet sind, den Spannungswandler mit einem den Spannungswandler beinhaltenden System zu verbinden, wobei die erste Leiterplatte und die zweite Leiterplatte über der dritten Leiterplatte angeordnet sind.
Beispiel 12. Spannungswandler nach einem der Beispiele 1 bis 11, wobei die zweite Leiterplatte keine eingebetteten Halbleiterchips aufweist.
Beispiel 13. Verfahren zum Herstellen eines Spannungswandlers, umfassend:
   Bereitstellen einer ersten Leiterplatte mit einem ersten Schaltungsabschnitt des Spannungswandler s, wobei der erste Schaltungsabschnitt zwischen Metalllagen der ersten Leiterplatte eingebettete Halbleiterchips umfasst,
   Bereitstellen einer zweiten Leiterplatte mit einem zweiten Schaltungsabschnitt des Spannungswandler s, und
   elektrisches Koppeln des ersten Schaltungsabschnitts mit dem zweiten Schaltungsabschnitt.
Beispiel 14. Verfahren nach Beispiel 13, wobei das Verfahren zur Herstellung des Spannungswandlers nach einem der Beispiele 1 bis 12 ausgestaltet ist. Obgleich in dieser Beschreibung spezifische Ausführungsbeispiele illustriert und beschrieben wurden, werden Personen mit üblichem Fachwissen erkennen, dass eine Vielzahl von alternativen und/oder äquivalenten Implementierung als Substitution für die spezifischen Ausführungsbeispiele, die in dieser Beschreibung gezeigt und beschrieben sind, ohne von dem Umfang der gezeigten Erfindung abzuweichen, gewählt werden können. Es ist die Intention, dass diese Anmeldung alle Adaptionen oder Variationen der spezifischen Ausführungsbeispiele, die hier diskutiert werden, abdeckt. Daher ist es beabsichtigt, dass diese Erfindung nur durch die Ansprüche und die Äquivalente der Ansprüche beschränkt ist.

## Patentansprüche

1. Spannungswandler (10), umfassend:
- eine erste Leiterplatte (11, 20, 50) mit einem ersten Schaltungsabschnitt (13, 60, 70) des Spannungswandlers (10), wobei der erste Schaltungsabschnitt (13, 60, 70) zwischen Metalllagen (31, 32) der ersten Leiterplatte (11, 20, 50) eingebettete Halbleiterchips (15, 30, 52) umfasst, und
- eine zweite Leiterplatte (12, 21, 51) mit einem zweiten Schaltungsabschnitt (14, 61, 71) des Spannungswandlers (10), wobei der erste Schaltungsabschnitt (13, 60, 70) elektrisch mit dem zweiten Schaltungsabschnitt (14, 61, 71) gekoppelt ist.

2. Spannungswandler (10) nach Anspruch 1, wobei der erste Schaltungsabschnitt (13, 60, 70) ausgelegt ist, im Betrieb des Spannungswandlers (10) geringere Ströme zu führen als der zweite Schaltungsabschnitt (14, 61, 71).

3. Spannungswandler (10) nach Anspruch 1 oder 2, wobei eine Anzahl von Metalllagen (31, 32) der ersten Leiterplatte (11, 20, 50) kleiner ist als eine Anzahl von Metalllagen (31, 32) der zweiten Leiterplatte (12, 21, 51).

4. Spannungswandler (10) nach einem der Ansprüche 1 bis 3, wobei der zweite Schaltungsabschnitt (14, 61, 71) eine Spule oder mehrere Spulen (62, 72) umfasst.

5. Spannungswandler (10) nach einem der Ansprüche 1 bis 4, wobei die erste Leiterplatte (11, 20, 50) und die zweite Leiterplatte (12, 21, 51) mechanische und elektrische Kopplungselemente (210, 53, 54, 55, 56) aufweisen, welche eingerichtet sind, die erste und die zweite Leiterplatte (10, 21, 50, 11, 22, 51) mechanisch zu koppeln und die elektrische Kopplung des ersten Schaltungsabschnitts (13, 60, 70) mit dem zweiten Schaltungsabschnitt (14, 61, 71) bereitzustellen.

6. Spannungswandler (10) nach Anspruch 5, wobei die mechanischen Kopplungselemente eine stufenförmige Aussparung in einer der ersten und der zweiten Leiterplatte (10, 21, 50, 11, 22, 51) umfassen, und wobei die andere der ersten und zweiten Leiterplatte (10, 21, 50, 11, 22, 51) in die stufenförmige Aussparung einpassbar ist.

7. Spannungswandler (10) nach einem der Ansprüche 1 bis 6, wobei die Halbleiterchips (15, 30, 52) Transistoren beinhalten, wobei die erste Leiterplatte (11, 20, 50) zudem in einer Draufsicht zumindest teilweise überlappend mit den Transistoren angeordnete Kondensatoren umfasst.

8. Spannungswandler (10) nach einem der Ansprüche 1 bis 7, wobei die erste Leiterplatte (11, 20, 50) eine Seitenwand oder mehrere Seitenwände (40A) aus wärmeleitfähigem Material umfasst.

9. Spannungswandler (10) nach Anspruch 8, wobei die mehreren Seitenwände (40A) eine U-Form bilden.

10. Spannungswandler (10) nach einem der Ansprüche 1 bis 9, wobei die Halbleiterchips (15, 30, 52) eine Fläche größer als 7 mm² aufweisen.

11. Spannungswandler (10) nach einem der Ansprüche 1 bis 10, weiter umfassend eine dritte Leiterplatte (22) mit Kontaktelementen (24, 25), welche eingerichtet sind, den Spannungswandler (10) mit einem den Spannungswandler (10) beinhaltenden System zu verbinden, wobei die erste Leiterplatte (11, 20, 50) und die zweite Leiterplatte (12, 21, 51) über der dritten Leiterplatte (22) angeordnet sind.

12. Spannungswandler (10) nach einem der Ansprüche 1 bis 11, wobei die zweite Leiterplatte (12, 21, 51) keine eingebetteten Halbleiterchips (15, 30, 52) aufweist.

13. Verfahren zum Herstellen eines Spannungswandlers (10), umfassend:
Bereitstellen einer ersten Leiterplatte (11, 20, 50) mit einem ersten Schaltungsabschnitt (13, 60, 70) des Spannungswandler (10)s, wobei der erste Schaltungsabschnitt (13, 60, 70) zwischen Metalllagen (31, 32) der ersten Leiterplatte (11, 20, 50) eingebettete Halbleiterchips (15, 30, 52) umfasst,
Bereitstellen einer zweiten Leiterplatte (12, 21, 51) mit einem zweiten Schaltungsabschnitt (14, 61, 71) des Spannungswandler (10)s, und
elektrisches Koppeln des ersten Schaltungsabschnitts (13, 60, 70) mit dem zweiten Schaltungsabschnitt (14, 61, 71).

14. Verfahren nach Anspruch 13, wobei das Verfahren zur Herstellung des Spannungswandlers (10) nach einem der Ansprüche 1 bis 12 ausgestaltet ist.
